Europäisches Patentamt

European Patent Office

Office européen des brevets

(11) Veröffentlichungsnummer: **0 025 129**
A2

(12) # EUROPÄISCHE PATENTANMELDUNG

(21) Anmeldenummer: 80104760.6

(22) Anmeldetag: 12.08.80

(51) Int. Cl.$^3$: **H 01 L 21/76**
H 01 L 21/312, H 01 L 21/316

(30) Priorität: 10.09.79 US 73593

(43) Veröffentlichungstag der Anmeldung:
18.03.81 Patentblatt 81/11

(84) Benannte Vertragsstaaten:
DE FR GB IT

(71) Anmelder: International Business Machines
Corporation
Armonk, N.Y. 10504(US)

(72) Erfinder: Lever, Reginald Frank
RD No. 1 Peekskill Hollow Road
Putnam Valley New York 10579(US)

(72) Erfinder: Mauer, John Lester
Holiday Point
Sherman Connecticut 06784(US)

(72) Erfinder: Michel, Alwin Earl
5 Grants Lane
Ossining New York 10562(US)

(72) Erfinder: Rothman, Laura Beth
Holiday Point
Sherman Connecticut 06784(US)

(74) Vertreter: Kreidler, Eva-Maria, Dr. rer. nat.
Schönaicher Strasse 220
D-7030 Böblingen(DE)

(54) Verfahren zur Herstellung von Isolationsbereichen in Silicium.

(57) Bei dem Verfahren zur Herstellung von Isolationsbereichen in Silicium werden tiefe, breite Gräben in die planare Oberfläche eines Siliciumsubstrats geätzt; eine dünne $SiO_2$-Schicht auf der planaren Oberfläche des Substrats und auf den Oberflächen der Gräben gebildet; eine Glasharzschicht auf die planare Oberfläche des Substrats aufgetragen und die Gräben mit Glasharz ausgefüllt und ein Teil des Glasharzes von der planaren Oberfläche des Substrats mittels Schleudern entfernt. Nach dem Härten des Substrats erfolgt eine Bestrahlung des Glasharzes in den Gräben mit Elektronenstrahlen, eine Entwicklung mit Lösungsmittel und Erhitzen des Substrats in Sauerstoffatmosphäre zur Umwandlung des Glasharzes in den Gräben in Siliciumdioxid. Um eine planare Oberfläche zu erhalten, wird eine Siliciumdioxidschicht auf die Oberfläche des Substrats aufgetragen und diese anschließend bis zum Siliciumsubstrat wieder abgetragen.

Das Verfahren wird in integrierten Schaltungen verwendet, um Schaltungselemente voneinander zu isolieren.

FIG. 5

- 1 -

Verfahren zur Herstellung von Isolationsbereichen in Silicium

Die Erfindung betrifft ein Verfahren zur Herstellung von Isolationsbereichen in Silicium. Mit dem Verfahren werden tiefe und breite, mit $SiO_2$ gefüllte Gräben, die in die planare Oberfläche eines Siliciumhalbleitersubstrats eingelegt sind, hergestellt.

In der Technologie hochintegrierter und dicht gepackter Schaltungen sind eingelegte dielektrische Isolationen, insbesondere Siliciumdioxidisolationen, zur Herstellung elektrisch isolierter Bereiche auf dem gleichen Siliciumchip zur Trennung von Basis- und Kollektorkontaktbereichen von Transistoren, die innerhalb dieser isolierten Bereiche hergestellt werden, bekannt. Eingelegte dielektrische Isolationen dienen auch zur Isolierung von Leitern, von dem darunterliegenden Siliciumsubstrat. Es ist auch bekannt, eingelegte dielektrische Isolationen zu erzeugen, indem zuerst Silicium selektiv von dem Substrat entfernt wird und dann die Gräben mit dielektrischem Material ausgefüllt werden. Ein Verfahren dieser Art ist beispielsweise in der US-Patentschrift 3 966 577 beschrieben.

Um den Bereich auf dem Siliciumchip zu verkleinern, der durch die dielektrisch gefüllten Gräben eingenommen wird, wurden Kathodenzerstäubungs-Ätzprozesse und reaktives Ionenätzen zur Herstellung der Gräben in dem Siliciumsubstrat angewendet. Ein Verfahren zum reaktiven Ionenätzen ist beispielsweise in der deutschen Patentanmeldung P 26 17 483.4 beschrieben. Mit diesem Verfahren können Gräben mit vertikalen Seitenwänden hergestellt werden, ohne daß eine Unterschneidung der Maske stattfindet und ohne daß mit der Tiefe sich verjüngende Wände erhalten werden, die charakteristisch für chemische Ätzprozesse sind.

FI 979 011

In der US-Patentschrift 4 104 086 ist ein Verfahren unter Anwendung des reaktiven Ionenätzens beschrieben, mit dem einwandfrei gefüllte, tiefe und schmale Nuten mit nahen vertikalen Wänden hergestellt werden können. Das Verfahren besteht in der Herstellung sich leicht verjüngender, schmaler Nuten, welche vergrabene hochdotierte Siliciumbereiche durchschneiden, einer thermischen Oxidation dieser Nuten und einer vollständigen Ausfüllung der noch verbleibenden Nuten mit einem dielektrischen Material, welches aus der Dampfphase abgeschieden wird. In der Patentschrift wird herausgestellt, daß sich leicht verjüngende Wände erforderlich sind, und es wird die Abhängigkeit der Qualität und der Planarität des dielektrischen Materials, das zur Füllung verwendet wird, vom Lochwand-Verjüngungswinkel und Lochdurchmesser diskutiert. Ein Schritt des Verfahrens besteht auch in dem Ätzen des Füllungsmaterials, welches den gesamten Wafer bedeckt, mit reaktiven Ionen, wobei das Material überall von der Oberfläche entfernt wird und nur in den Isolationsgräben zurückbleibt.

Die US-Patentschrift 4 139 442 betrifft ein reaktives Ionenätzverfahren zur Herstellung tief eingelegter oxidierter Bereiche in Silicium. Eine Anzahl tiefer Gräben werden in einem Siliciumwafer durch reaktives Ionenätzen (RIE) hergestellt. In einer ersten Ausführungsform weisen die Gräben alle die gleiche Breite auf. Eine Abschirmmaske wird selektiv während eines Teils des RIE-Verfahrens angewendet, um Gräben ungleicher Tiefe herzustellen. Die Grabenwände werden thermisch oxidiert, um gleichzeitig alle Gräben mit Oxid vollständig zu füllen. In einer zweiten Ausführungsform sind die Gräben von gleicher Tiefe und Breite und einheitlichem Abstand. In einer besonderen Ausführungsform der zweiten Serie ist die Weite der Gräben gleich dem Abstand zwischen den Gräben, und die Gräben werden durch thermische Oxidation vollständig mit Oxid ausgefüllt, während gleichzeitig das Silicium zwischen den Gräben vollständig in Siliciumdioxid umgewandelt wird. In einer anderen Ausführungsform der zweiten Serie sind die Gräben breiter als der Abstand zwischen den Gräben, und die Gräben werden durch thermische Oxidation nur teilweise mit Oxid ausgefüllt, während das dazwischen liegende Silicium vollständig in Siliciumdioxid umgewandelt wird. In diesem Fall werden die Gräben durch die Abscheidung eines geeigneten Materials, beispielsweise durch pyrolytisch abgeschiedenes Siliciumdioxid, vollends ausgefüllt.

Es sind zahlreiche Technologien, Verfahren und Annäherungen bekannt, um dielektrische Isolationen in integrierten Halbleiterstrukturen herzustellen. Ein repräsentativer Querschnitt des Standes der Technik wird nachfolgend angegeben und kurz diskutiert.

In der US-Patentschrift 3 442 011 wird ein Verfahren zur Isolation einzelner Anordnungen in einer integrierten Halbleiterschaltung angegeben. Bei diesem Verfahren werden Teile eines Halbleiterwafers selektiv aus dem halbleitenden in den isolierenden Zustand umgewandelt unter Zurücklassung nichtumgewandelter Bereiche einkristallinen halbleitenden Materials, die gegeneinander durch die isolierenden Teile des Materials isoliert sind. Die Umwandlung erfolgt dadurch, daß die Teile des Halbleiterwafers, welche halbleitend bleiben sollen, mit einer Maske bedeckt werden und anschließend die nichtmaskierten Bereiche chemisch mit Sauerstoff umgesetzt werden unter Ausbildung eines neuen Materials (im Fall von Sauerstoff unter Ausbildung von Siliciumdioxid), welches isolierend ist. In den Bereichen des nichtumgewandelten Halbleitermaterials werden anschließend Diffusionen gemacht oder Epitaxieabscheideverfahren durchgeführt unter Ausbildung von Dioden- oder Transistorstrukturen beispielsweise einer integrierten Schaltung, die miteinander durch ein gemeinsames Substrat verbunden sind und durch die isolierenden Teile durch das Substrat elektrisch isoliert sind.

In der US-Patentschrift 3 575 740 wird ein Verfahren zur Herstellung planarer, dielektrisch isolierter integrierter Schaltkreise beschrieben. Das Verfahren umfaßt das Ätzen von Isolationskanälen in ein Halbleitersubstrat durch eine geeignete Maske. Das Maskenmuster ist so ausgelegt, daß an bestimmten Stellen in den Isolationskanälen eine Ätzung in tiefere Bereiche stattfindet. Eine dielektrische Schicht wird auf den freiliegenden Oberflächen der Isolationskanäle gebildet und ein Halbleitermaterial wird in den Kanälen aufgewachsen. Die tiefer geätzten Bereiche, die nun mit dielektrischem Isolationsmaterial gefüllt sind, werden als Tiefenmarke verwendet bei der Ausbildung einer dielektrischen Schicht von der Halbleiteroberfläche aus, die derjenigen, von der aus geätzt wurde, gegenüberliegt. Die Tiefenmarke kann entweder in einem Tiefenätzverfahren oder in einem Läpp-Verfahren verwendet werden. Der letzte Isolationsschritt besteht dann in der Fortführung der dielektrischen Schicht über die Tiefenmarke hinaus zu dem Hauptteil der Isolationskanäle, um vollständig isolierte Inseln von Halbleitermaterial in dem Halbleitersubstrat herzustellen.

In einem in der US-Patentschrift 3 648 125 beschriebenen Verfahren wird eine dünne Siliciumepitaxieschicht auf einem Siliciumsubstrat gebildet und durch ein Gitter aus oxidierten Bereichen eines epitaktischen Siliciummaterials in elektrisch isolierte Bereiche unterteilt, welche sich durch die Epitaxieschicht zu einem lateral sich ausdehnenden PN-Übergang erstrecken.

Die US-Patentschrift 3 698 966 betrifft ein Verfahren zur Herstellung von Feldeffektbauteilen mit Oxidisolation.

FI 979 011

Oxidfilme und eine Nitridschicht werden selektiv auf der Oberfläche eines Halbleiterwafers gebildet, um Bereiche auf dem Wafer zu definieren, in denen die Feldeffektbauteile ausgebildet werden sollen. Die Nitridschicht maskiert den inneren Oxidfilm, wenn zur Ausbildung lateral isolierter Halbleiterinseln eine Oxidschicht um die maskierten Bereiche herum gebildet wird, in denen die Feldeffektbauteile hergestellt werden sollen. Ein Teil der Nitridschicht wird dann verwendet zur Maskierung des Oxidfilms, der die Gatezone des Feldeffektbauteils definiert. Durch Diffusion werden leitende Bereiche in der Insel ausgebildet, wobei Nitridschichten die Kontaktbereiche der Feldeffektbauteile maskieren. Dann werden Kontakte in den Kontaktbereichen hergestellt.

Die US-Patentschrift 3 796 613 betrifft ein Verfahren zur Herstellung einer dielektrisch isolierten Halbleitervorrichtung. Es wird ein Verfahren beschrieben zur Herstellung von dielektrisch isolierten Halbleitervorrichtungen mit einer stegartigen Verbindungszone, die besonders als Bestandteil integrierter Schaltungen geeignet sind. Die Struktur ist zur Herstellung integrierter Schaltungen einschließlich Feldeffekt und/oder bipolaren Transistoren verwendbar, bei denen erhebliche Einsparungen im Oberflächenbereich und eine Herabsetzung der Kapazität im Gegensatz zu bisher bekannten Technologien erreicht werden können. Das Verfahren besteht in der Ausbildung einer Schicht aus dielektrischem Material auf einem Halbleiterkörper mit einer diffundierten Halbleiterzone, in der eine bipolare Vorrichtung gebildet werden soll. In der Isolationsschicht wird eine Öffnung hergestellt, um einen Teil der Oberfläche der diffundierten Halbleiterzone in dem Halbleiterkörper freizulegen. In einem Epitaxieprozeß wird eine Siliciumschicht auf der Oberfläche abgeschieden. Im Bereich des freigelegten Siliciums wächst einkristallines Silicium auf, und wenn eine diffundierte Halbleiterzone in dem Substrat vorhanden ist, bildet

- 6 -

sich im gleichen Bereich von der vergrabenen diffundierten Zone aus durch Ausdiffusion eine stegartige Zone. Polykristallines Silicium wächst auf dem dielektrischen Material auf. Die stegartige Zone wird in einer einkristallinen Epitaxieschicht eines anderen Dotierungstyps gebildet. Zwei aktive Elemente eines bipolaren Transistors, wie der Emitter und die innere Basiszone, werden dann in der gleichen einkristallinen Epitaxieschicht gebildet, während der inaktive Bereich, der äußere Teil der Basis, in polykristallinem Silicium gebildet wird. Durch die dielektrische Schicht wird eine Verbindung zu dem dritten Element des Transistors, zur Kollektorzone, geschaffen.

In der US-Patentschrift 3 873 383 wird ein Verfahren zur Herstellung einer Halbleitervorrichtung in der größeren Oberfläche eines Halbleiterkörpers beschrieben, bei dem ein Muster aus Isolationsmaterial eingelassen ist und eine weitere dotierte Zone in Nachbarschaft zu dem eingelassenen Muster vorgesehen ist. Vor der Herstellung des eingelassenen Musters wird eine Maske zur Oxidation und Verunreinigungsdiffusion hergestellt mit Öffnungen in denjenigen Bereichen, in denen das eingelassene Muster erzeugt werden soll, dann wird der Halbleiterkörper durch die Öffnungen dotiert und anschließend oxidiert, wodurch eine Oxid-Sperrschichtisolation und ein Kanalstopper erhalten werden.

In der US-Patentschrift 3 886 000 wird ein Verfahren zur Kontrolle der dielektrischen Isolation einer Halbleitervorrichtung beschrieben. Hierzu wird eine dielektrische Isolationszone in einem Siliciumsubstrat gebildet, indem man Ausnehmungen, die in der Epitaxieschicht auf dem Substrat und einer Schicht von Siliciumoxynitrid ($SiO_xN_y$), welche sich auf der Oberfläche der Epitaxieschicht des Substrats befindet, angeordnet sind, oxidiert. Während der Oxidation der Ausnehmungen wird die Siliciumoxynitrid-Schicht thermisch

FI 979 011

oxidiert unter Ausbildung einer elektrisch isolierenden Schicht von Siliciumdioxid auf der Oberfläche der Epitaxieschicht, die homogen mit dem Siliciumdioxid der dielektrischen Isolationszone ist. Der Brechungsindex der Siliciumoxynitridschicht wird in Abhängigkeit ihrer Dicke so gewählt, daß mit der Beendigung der Oxidation der Ausnehmungen, in denen die dielektrische Isolationszone gebildet wird, eine gewünschte Schichtdicke der Siliciumdioxidschicht erhalten wird. Der Brechungsindex der Siliciumoxynitridschicht liegt vorzugsweise zwischen 1,55 und 1,70.

In der US-Patentschrift 3 894 893 ist ein Verfahren zur Herstellung von monokristallinen-polykristallinen Halbleitervorrichtungen beschrieben. Die beschriebene Vorrichtung besteht aus einer Vielzahl polykristalliner und monokristalliner Bereiche, welche epitaktisch auf ein Substrat aufgewachsen werden, so daß zwischen jedem der beiden Bereiche wenigstens ein Übergang monokristallin-polykristallin gebildet wird und der konventionelle Isolationsprozeß durch Diffusion, welcher schwierig durchzuführen ist, vollständig eliminiert werden kann.

In dem in der US-Patentschrift 3 900 350 beschriebenen Verfahren werden Siliciumdioxidbereiche, welche in Silicium eingelassen sind, durch eine Oxidation durch eine Maske hergestellt. In diesem Verfahren ist eine Zwischenschicht aus polykristallinem Silicium zwischen der Unterlage und der Oxidationsmaske vorgesehen.

In der US-Patentschrift 3 935 328 ist ein Verfahren zur Herstellung dielektrischer Isolationen in einer Epitaxieschicht eines zusammengesetzten Halbleiters beschrieben, bei dem eine Plasmaoxidation angewendet wird.

FI 979 011

- 8 -

In der US-Patentschrift 3 998 673 ist ein Verfahren zur Herstellung elektrisch isolierter Bereiche in integrierten Schaltungen unter Anwendung selektiven Epitaxiewachstums beschrieben. In dem beschriebenen Verfahren werden elektrische Isolationsbereiche in integrierten Schaltungen in Form von dielektrischen Gräben, welche die Bereiche und die PN-Übergänge, die unter diesen Bereichen liegen, umgeben, hergestellt. Die Gräben oder Rillen werden in das Substrat vor der Ausbildung der vergrabenen Isolationsschicht oder weiterer Halbleitervorrichtungen geätzt. Ein dielektrisches Material wie Siliciumdioxid wird in den Rillen oder Gräben abgeschieden und polykristallines Silicium wird auf der Oberfläche des Wafers aufgewachsen, bis die Rillen oder Gräben ausgefüllt sind. Das überschüssige Polysilicium, das auf der Oberfläche des Wafers gebildet wurde, wird dann durch mechanisches Läppen oder Polieren entfernt. Da keine Dotierung oder ein Epitaxiewachstum stattgefunden hat, kann der Wafer direkt bis zum Substrat geläppt werden, um alles Polysilicium oder Oxid von der Oberfläche zu entfernen und Rillen oder Gräben, die mit dielektrischem Material ausgekleidet und mit Polysilicium ausgefüllt sind, erhalten werden.

In der US-Patentschrift 4 001 465 wird ein Verfahren zur Herstellung von Halbleitervorrichtungen beschrieben, bei dem eine ring- oder gitterförmige Nut oder ein Graben in die Oberfläche einer Siliciummonokristallschicht geätzt wird. Wenigstens eine Begrenzung der so geätzten Nut oder des Grabens wird mit einer streifenförmigen Schicht eines die Oxidation blockierenden Materials, beispielsweise $Si_3N_4$ bedeckt, und der Bereich des Substrats in Nachbarschaft der $Si_3N_4$-Schicht und/oder der Bereich des Substrats, der durch eine solche Schicht eingeschlossen wird, wird mit einer relativ dicken $SiO_2$-Schicht versehen, die sich tiefer in die Siliciumoberfläche erstreckt als die $Si_3N_4$-Schicht, während

FI 979 011

- 9 -

die Siliciumoberfläche in der Nut oder in dem Graben unbeschichtet bleibt. Die so erhaltene Anordnung wird dann thermisch oxidiert unter Bedingungen, die ausreichen, um die Nut oder den Graben wenigstens teilweise mit Siliciumdioxid zu füllen. Anschließend wird die die Oxidation blockierende Schicht und wenigstens ein Teil der $SiO_2$-Schicht außerhalb des Rings oder des gitterförmigen Grabens von der monokristallinen Oberfläche durch ein geeignetes Ätzmittel entfernt, und in der so freigelegten Siliciumoberfläche werden in dem weiteren Verfahren kleine PN-Übergänge erzeugt.

Aufgabe der Erfindung ist, ein verbessertes Verfahren zur Herstellung von Isolationsbereichen in Silicium anzugeben. Die Erfindung befaßt sich mit Siliciumdioxid gefüllten Gräben, die in die planare Oberfläche eines Siliciumhalbleitersubstrats eingelegt sind.

Die Aufgabe der Erfindung wird gelöst durch ein Verfahren, das gekennzeichnet ist durch folgenden Verfahrensschritte:

a) Ätzen tiefer breiter Gräben in die planare Oberfläche eines Siliciumsubstrats;

b) Bilden einer dünnen $SiO_2$-Schicht auf der planaren Oberfläche des Siliciumsubstrats und auf den freiliegenden Oberflächen der Gräben;

c) Auftragen von Glasharz auf die planare Oberfläche und Ausfüllen der Gräben in dem Substrat mit Glasharz;

d) Entfernen eines Teils des Glasharzes von der planaren Oberfläche des Substrats mittels Schleudern;

e) Härten des Substrats bei niedriger Temperatur;

FI 979 011

f)  Bestrahlen des Glasharzes in den Gräben mit Elektronenstrahlen;

g)  Entwickeln des Glasharzes in einem Lösungsmittel;

h)  Erhitzen des Substrats in Sauerstoffatmosphäre zur
    Umwandlung des Glasharzes in den Gräben in Siliciumdioxid;

i)  Auftragen einer Siliciumdioxidschicht zum Erhalt einer
    planaren Oberfläche auf dem Substrat und

j)  Abtragen des Siliciumdioxids bis zum Siliciumsubstrat.

Das erfindungsgemäße Verfahren stellt ein verbessertes Verfahren zur Herstellung planarer, tiefer Oxidisolationen
dar, bei dem das Glasharz gleichzeitig als Elektronenstrahlresist und zur Herstellung der Oxidisolation in den tiefen
Gräben verwendet wird. Ein weiterer Vorteil des Verfahrens
besteht darin, daß planare, tiefe Oxidisolationen erzeugt
werden können, die unabhängig von der Größe der Gräben
sind.

Das Glasharz wird als Polymer definiert, das alternierend
aus Atomen von Silicium und Sauerstoff besteht, wobei die
Siliciumatome organische Reste tragen. Die Typen der Reste
und der Grad der organischen Substitution bestimmen, ob das
Harz in flüssiger oder fester Form vorliegt und welche Eigenschaften das gehärtete Harz aufweist. Eine thermische
Behandlung gestattet, einen Film aus diesen Polymeren unter
Eliminierung der organischen Reste in Siliciumdioxid umzuwandeln. Der Ausdruck Glasharz wird in der US-Patentschrift
3 985 597 mit dem Titel "Verfahren zur Herstellung eines
passivierten metallischen Leiterzugsystems mit einer planaren Oberfläche" und in der US-Patentschrift 4 004 044 mit

FI 979 011

dem Titel "Verfahren zur Herstellung eines Filmmusters unter Anwendung einer transparenten Abhebemaske" definiert.
Die Verwendung von Polysiloxanen als Elektronenstrahl-Resistmaterialien wurde in der Literatur bereits beschrieben,
beispielsweise von E. D. Roberts in "The Preparation and
Properties of a Polysiloxane Electron Resist", J. Electrochem. Soc. Vol. 120, Nr. 12, Dezember 1973.

Eine beträchtliche Anzahl von Glasharzen sind im Handel
erhältlich. Es handelt sich hierbei um Produkte wie Dow-
Corning 805, Owens-Illinois 650, Dow-Corning 649, General
Electric SR 124 und General Electric SR 125.

Wie zuvor beschrieben, handelt es sich bei dem erfindungsgemäßen Verfahren um ein Verfahren zur Herstellung einer
planaren, tiefen Oxidisolation, bei dem tiefe, breite, mit
Siliciumdioxid gefüllte Gräben in die planare Oberfläche
eines Siliciumhalbleitersubstrats eingelegt werden und das,
wie zuvor angegeben, gemäß den Verfahrensschritten a bis j
durchgeführt wird.

Anstelle von Verfahrensschritt i können die Schritte i-1
und i-2 durchgeführt werden:

i-1  Auftragen einer zweiten dünnen Schicht aus Glasharz durch Aufschleudern;

i-1 Umwandlung dieses Glasharzes in Siliciumdioxid.

In einer anderen vorteilhaften Ausgestaltung der Erfindung
kann nach dem Schritt b und vor Schritt c der Schritt b-1
durchgeführt werden:

b-1  Bilden einer dünnen Schicht von Siliciumnitrid auf der
     dünnen Siliciumdioxid-Schicht, die gemäß Schritt b
     hergestellt wurde.

FI 979 011

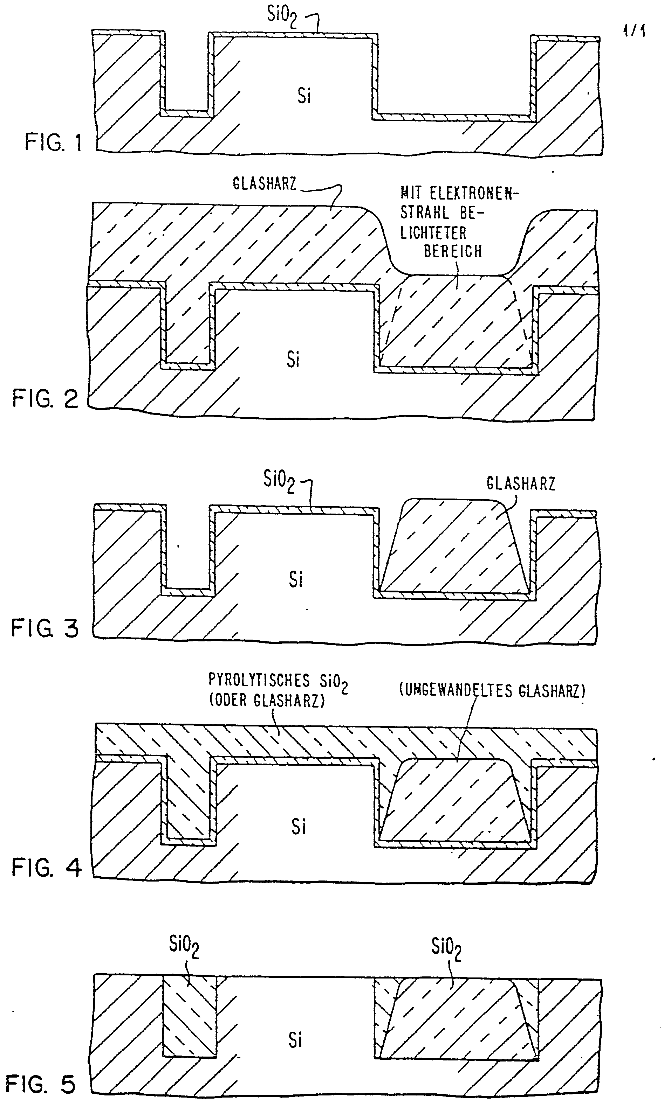

Die Fign. 1 bis 5 stellen vereinfachte Querschnitte eines Teils einer Halbleiterstruktur dar, aus denen die aufeinanderfolgenden Schritte des Verfahrens zur Herstellung einer planaren, tiefen Oxidisolation gemäß der Erfindung ersichtlich sind. Beim Chipdesign für sehr kleine Bauteile der VLSI-Technologie werden als Isolationsbereiche tiefe Gräben mit verschiedenen Dimensionen gefordert. Die Tiefe dieser tiefen Gräben beträgt etwa 4 μm, während die Breite zwischen 2 und 50 μm variiert. Bei den größeren Gräben tritt ein besonderes Problem auf, weil das aus der Dampfphase abgeschiedene Oxid, das zur Auffüllung der Gräben verwendet wird, über diesen größeren Dimensionen (>8 μm) nicht planar ist.

Bekannte Verfahren zur Lösung dieses Problems machen von großen Filmdicken oder einer extrem schwierigen Lithographie Gebrauch. Die Filmdicken dieser Verfahren (∿8 μm) führen zu wesentlichen Unebenheiten und demzufolge zu einer Überätzung an der Siliciumoberfläche.

Mit dem nachfolgenden erfindungsgemäßen Verfahren wird eine planare, tiefe Oxidisolation erhalten, wobei die größeren Gräben vor dem Aufbringen des letzten Oxids gefüllt werden.

Das Verfahren umfaßt:

1. Ausbilden der gewünschten Geometrien der tiefen Gräben in dem Silicium durch reaktives Ionenätzen, wie in Fig. 1 dargestellt ist. Das reaktive Ionenätzen kann in einem chlorhaltigen Plasma wie $Ar/Cl_2$-Mischungen oder $Ar/CCl_4$-Mischungen durchgeführt werden. Es kann auch ein fluoriertes Gas wie $CF_4$ verwendet werden. Andere Verfahren zur Herstellung der tiefen Gräben in Silicium sind Kathodenzerstäubungsätzen in einem inerten Gas wie Argon oder Fräsen mit einem Ionenstrahl.

FI 979 011

2.  Oxidieren der Wafer unter Ausbildung einer dünnen
    Schicht (200 nm) thermischen Siliciumdioxids über dem
    Silicium.

3.  Pyrolytisches Aufwachsen einer dünnen Schicht (30 nm)
    von $Si_3N_4$ (wahlweise als Natriumsperrschicht).

4.  Auftragen eines Glasharzes (Polysiloxan) auf den Wafer
    und Abschleudern. Der Feststoffgehalt der Lösung und
    die Schleudergeschwindigkeit können verändert werden,
    um die gewünschte Filmdicke zu erhalten. Der Film
    sollte etwas dicker sein als die Tiefe des Grabens,
    der aufzufüllen ist (Fig. 2). Die erforderliche Dicke
    des Glasharzes hängt von dem Silicium-Sauerstoffgehalt
    des Polysiloxans ab. Ein höherer Silicium-Sauerstoffgehalt führt zu einem geringeren Dickenverlust während
    der Umwandlung in Siliciumdioxid, und deshalb kann anfänglich eine dünnere Glasharzschicht aufgetragen werden.

5.  Härten bei niedriger Temperatur ($80^{o}C$) auf einer hei-
    ßen Platte zur Entfernung des Lösungsmittels.

6.  Bestrahlen mit einem Ionenstrahl. Das Glasharz ist ein
    negativer Elektronenstrahlresist. Die breiten Gräben
    werden in der Weise, wie in Fig. 2 gezeigt ist, belichtet. Eine Dosis von 20 $\mu C/cm^2$ oder darüber ist
    bei 25 keV Beschleunigung des Elektronenstrahls erforderlich.

7.  Entwickeln in Aceton oder einem ähnlichen Lösungsmittel in Abhängigkeit von dem verwendeten Glasharz
    (Fig. 3).

8. Umwandeln des Glasharzes in Siliciumdioxid durch Erhitzen in einem Ofen in einer Sauerstoffatmosphäre auf ungefähr 600$^{o}$C (Fig. 4).

9a. Auftragen einer zweiten dünnen Schicht von Glasharz (∿2 μm), Umwandeln in Siliciumdioxid oder

9b. Abscheiden einer dünnen Schicht pyrolytischen Sili- ciumdioxids (∿2 μm).

Die Oberfläche sollte zu diesem Zeitpunkt aus Siliciumdioxid bestehen und planar sein, wie aus Fig. 4 ersichtlich ist.

10. Abätzen bis zur Siliciumoberfläche in einem $CF_4$ oder $H_2$-$CF_4$-Plasma. Dabei wird, wie aus Fig. 5 ersichtlich ist, eine planare Oxidisolation erhalten.

Das erfindungsgemäße Verfahren ist einmalig, weil das Glasharz gleichzeitig als Elektronenstrahlresist und als Oxidisolation für tiefe Gräben verwendet wird. Mit dem erfindungsgemäßen Verfahren wird eine planare Oberfläche unabhängig von der Breite der Gräben erhalten, weil die breiten Gräben separat gefüllt werden.

Es wurden fünf im Handel erhältliche Polysiloxane und ihre Verwendung in dem zuvor beschriebenen Isolationsprozeß mit tiefen Gräben ausgewertet. Das am besten geeignete Material ist ein Material mit der Bezeichnung Dow-Corning 805; alle der geprüften Materialien sind für das Verfahren jedoch ge- eignet. Wesentliche Unterschiede zwischen den einzelnen Materialien betreffen ihre Elektronenstrahlempfindlichkeit und den anschließenden Dickenverlust während der Entwicklung. Nachfolgend werden Verfahren für jedes einzelne der Materialien beschrieben. Alle Polysiloxane wurden vor ihrer Verwendung filtriert. Es wurden Silberfilter mit einer Porengröße von 1,0 µm in einer Filtervorrichtung unter Druck verwendet. Alle Materialien, die im Handel erhältlich waren, enthielten eine große Anzahl von Teilchen und Gelen, welche entfernt werden mußten, um hochwertige Filme zu erhalten.

In allen nachfolgend beschriebenen Verfahren wird davon ausgegangen, daß die Gräben in dem Siliciumwafer bereits definiert wurden. Es gibt eine Anzahl von Verfahren zum Ätzen von Siliciumgräben, beispielsweise reaktives Ionenätzen, Kathodenzerstäubungsätzen oder Fräsen mit einem Ionenstrahl. Nachdem die Gräben geätzt sind, werden dünne Schichten eines thermischen Oxids oder von Siliciumnitrid niedergeschlagen. Die Anwesenheit einer Siliciumnitridschicht dient dem Zweck, als Sperrschicht oder Gettersubstanz für ionische Verunreinigung zu wirken. Das thermische Oxid ist erforderlich, um eine gute Adhäsion des Siliciumnitridfilms auf dem Siliciumwafer zu gewährleisten. Es wird von einer Grabentiefe von 4,0 µm ausgegangen. Für weniger tiefe Gräben würde man dünnere Glasharzschichten verwenden. Dies kann erreicht werden, indem die Beschichtungsgeschwindigkeit erhöht oder das Polysiloxan vor der Beschichtung des Wafers verdünnt wird.

I <u>Dow-Corning 805</u>

1.  Anwenden von HMDS (Hexamethyldisilazan) auf den Wafer. Nach einer Wartezeit von 30 Sekunden 30 Sekunden dauerndes Schleudern bei 2000 Umdrehungen/Min. Das HMDS wirkt als Adhäsionspromotor.

2.  Anwenden von Dow-Corning 805 Polysiloxan bei vollständiger Bedeckung des Wafers. Nach einer Wartezeit von 30 Sekunden 300 Sekunden dauerndes Schleudern des Wafers bei 2000 Umdrehungen/Min.

- 16 -

3.  Aushärten des Wafers auf einer heißen Platte bei 100°C und einer Dauer von 45 Minuten.

4.  Elektronenstrahlbelichtung mit 20 µC/cm$^2$.

5.  Entwickeln - 20 Sekunden in Aceton und anschließendes Abschrecken mit Wasser/Aceton (1:1 Wasser/Aceton).

6.  Härten auf einer Heizplatte bei 200°C und einer Dauer von 15 Minuten.

7.  Endgültige Umwandlung in $SiO_2$ in einem Röhrenofen in Sauerstoffatmosphäre bei 600°C und einer Dauer von 60 Minuten.

Zu dem zuvor beschriebenen Verfahren ist zu bemerken, daß die Aushärtzeit bei 100°C zwischen 30 und 60 Minuten variieren kann und trotzdem eine gute saubere Entwicklung erhalten wird. Eine anfängliche Aushärtung bei 100°C und einer Dauer von 90 Minuten führt zu einem Harz, das nicht mehr entwickelbar ist. Eine Aushärtung bei oder über 120°C führt ebenfalls zu einem Harz, das in Aceton nicht mehr entwickelt werden kann, aber mit einem langen Entwicklungszyklus von 10 Minuten in N-Methylpyrrolidinon (NMP) kann eine Entwicklung des Harzes in diesem Zustand durchgeführt werden.

Elektronenstrahlbelichtungen mit höherer Energie bewirken einen etwas geringeren Dickenverlust nach der Entwicklung, eine Bestrahlung mit 20 µC/cm$^2$ ist jedoch ausreichend.

Die folgenden Lösungsmittel wurden als mögliche Entwickler eingesetzt: Xylol, Toluol, n-Butylacetat (NBA), Isopropanol, Methanol, Aceton, N-Methylpyrrolidinon (MNP). Mit Xylol, Toluol und NBA konnte eine Entwicklung des Musters nach ei-

FI 979 011

ner Bestrahlung mit einer Dosis von 20 µC/cm$^2$ durchgeführt werden. Das erhaltene Muster war jedoch nicht so klar definiert wie bei der Verwendung von Aceton als Entwickler.

8.   Die Planarisierung kann vorgenommen werden entweder
   a) durch mehr Glasharz oder
   b) durch SiO$_2$, welches aus der Dampfphase abgeschieden wird.

8a)   Anwenden einer verdünnten Lösung von DC 805 (5:1 DC 805 : Xylol) und nach einer Wartezeit von 30 Sekunden 30 Sekunden Schleudern bei 4000 Umdrehungen/Min. Härten auf einer Heizplatte bei 100$^O$C während 15 Minuten. Härten auf einer Heizplatte bei 200$^O$C während 15 Minuten. Härten in einem Ofen (O$_2$-Atmosphäre) bei 600$^O$C während 60 Minuten. Reaktives Ionenätzen (RIE) in einem Diodensystem bei 13,56 MHz, 0,25 Watt/cm$^2$ und 20 Millitorr CF$_4$.

8b)   Abscheiden von 2,0 µm SiO$_2$ aus der Dampfphase und reaktives Ionenätzen wie zuvor beschrieben.

II General Electric SR 124

1.   Anwenden von HMDS auf dem Wafer. Nach einer Wartezeit von 30 Sekunden 30 Sekunden Schleudern bei 2000 Umdrehungen/Min.

2.   Anwenden von GE-SR 124 Polysiloxan auf den Wafer. Nach einer Wartezeit von 30 Sekunden 30 Sekunden Schleudern bei 2000 Umdrehungen/Min.

3.   Härten auf einer Heizplatte bei 100$^O$C während 45 Minuten.

FI 979 011

4.  Elektronenstrahlbelichtung bei 20 $\mu C/cm^2$.

5.  Entwickeln in Aceton - 15 Sekunden und anschließendes Abschrecken mit Wasser/Aceton (1:1) und Trockenblasen mit Stickstoff.

6.  Härten auf einer Heizplatte bei 200$^o$C während 15 Minuten.

7.  Endgültige Umwandlung in $SiO_2$ in einem Röhrenofen in Sauerstoffatmosphäre bei 600$^o$C während 60 Minuten.

8.  Gleiches Verfahren wie für DC 805.

Die Aushärtzeit ist nicht kritisch und liegt zwischen 30 bis 90 Minuten. Die anfängliche Aushärtzeit kann auch bis zu 125$^o$C ansteigen, ohne daß das Entwickeln des Harzes beeinträchtigt wird. Es findet jedoch eine schlechtere Entwicklung bei einem Material statt, das bei 125$^o$C während 120 Minuten gehärtet worden war. Auch die Überschreitung von 200$^o$C führt dazu, daß das Muster nicht mehr entwickelt werden kann.

III General Electric SR 125

Die Verfahrensschritte für SR 124 und 125 sind identisch. Die Unterschiede liegen im Feststoffgehalt und im Lösungsmittelsystem des Polysiloxans, wodurch etwas unterschiedliche Filmdicken erhalten werden. Nach einer Härtung bei 200$^o$C ist ein Film aus SR 124 5,8 $\mu m$ dick, während ein solcher aus SR 125 4,8 $\mu m$ dick ist. Ein anderer Unterschied besteht in der kritischen Temperatur und der Zeit, der die Materialien unterworfen werden können, damit sie noch entwickelbar sind. Das SR 125 Material kann nicht mehr entwickelt werden, wenn die anfängliche Härtung bei 100$^o$C erfolgt und länger als 45 Minuten dauert.

FI 979 011

IV <u>Owens-Illinois 650</u>

Dieses Material ist in fester Form erhältlich und muß in Lösung gebracht werden. Es ist in einer Reihe von Lösungsmitteln löslich. Verwendet wurde eine 50%ige Lösung in n-Butylacetat für das nachfolgende Verfahren:

1. Anwenden von HMDS auf den Wafer. Nach einer Wartezeit von 30 Sekunden 30 Sekunden Schleudern bei 2000 Umdrehungen/Min.

2. Anwenden einer 50%igen Lösung von OI-650. Nach einer Wartezeit von 30 Sekunden 30 Sekunden Schleudern bei 2000 Umdrehungen/Min.

3. Härten auf einer Heizplatte bei 80°C während 10 Minuten.

4. Elektronenstrahlbelichtung bei 20 $\mu C/cm^2$.

5. Entwickeln in Aceton - 20 Sekunden und Abschrecken mit Wasser/Aceton und Trockenblasen mit Stickstoff.

6. Härten auf einer Heizplatte bei 200°C während 15 Minuten.

7. Endgültige Umwandlung in $SiO_2$ in Sauerstoffatmosphäre (Röhrenofen) bei 600°C während 60 Minuten.

8. Gleiches Verfahren, wie zuvor beschrieben.

Das Owens-Illinois 650 Glasharz reagiert sehr empfindlich auf den anfänglichen Härtungsschritt. Wenn es 30 Minuten lang bei 80°C gehärtet wird, kann es nach Elektronenbestrahlung nicht mehr einwandfrei entwickelt werden. Eine

FI 979 011

Härtung bei 100°C führt auch dazu, daß das Harz nicht mehr entwickelbar ist. Weil der Harzfilm wegen der Härtung bei niedriger Temperatur vor der Elektronenbestrahlung sehr instabil ist, wurden eine Reihe von Effekten bezüglich der Lagerbeständigkeit oder der Alterung beobachtet. Die Ergebnisse, die mit diesem Material erhalten wurden, waren am schwierigsten zu reproduzieren. Bei einer Alterung der Filme nimmt ihre Entwicklungszeit zu, wobei auch eine starke Abhängigkeit von der Umgebung, in der die Alterung stattfindet, vorhanden ist.

## I Dow-Corning 649

Dieses Material ist in Lösung erhältlich. Das Verfahren ist identisch mit dem für das OI-650 Material mit der Ausnahme, daß das Material gegenüber etwas längeren Härtungszeiten bei 80°C stabil ist. Ein anfängliches Härten von bis zu 45 Minuten bei 80°C führt zu gut entwickelbaren Mustern. Als bestes Lösungsmittel für die Entwicklung dieses Materials ist NMP geeignet, wobei die Dauer 30 Sekunden beträgt und anschließend mit Wasser gespült und getrocknet wird.

Das beschriebene Verfahren ist nicht auf die fünf im Handel erhältlichen Polysiloxanharze beschränkt. Auch wurden nicht alle Lösungsmittel, die zur Entwicklung geeignet sind, bestimmt. Es können daher noch bessere Entwickler gefunden werden. Bei der praktischen Durchführung der Erfindung wurden die zuvor beschriebenen Materialien (Polysiloxane und Lösungsmittel), welche leicht erhältlich und zu handhaben sind, verwendet.

PATENTANSPRÜCHE

1.  Verfahren zur Herstellung von Isolationsbereichen in Form tiefer und breiter, mit $SiO_2$ gefüllter Gräben, die in die planare Oberfläche eines Siliciumhalbleitersubstrats eingelegt sind, gekennzeichnet durch folgende Verfahrensschritte:

    (a) Ätzen tiefer breiter Gräben in die planare Oberfläche eines Siliciumsubstrats;

    (b) Bilden einer dünnen $SiO_2$-Schicht auf der planaren Oberfläche des Siliciumsubstrats und auf den freiliegenden Oberflächen der Gräben;

    (c) Auftragen von Glasharz auf die planare Oberfläche und Ausfüllen der Gräben in dem Substrat mit Glasharz;

    (d) Entfernen eines Teils des Glasharzes von der planaren Oberfläche des Substrats mittels Schleudern;

    (e) Härten des Substrats bei niedriger Temperatur;

    (f) Bestrahlen des Glasharzes in den Gräben mit Elektronenstrahlen;

    (g) Entwickeln des Glasharzes in einem Lösungsmittel;

    (h) Erhitzer des Substrats in Sauerstoffatmosphäre zur Umwandlung des Glasharzes in den Gräben in Siliciumdioxid;

    (i) Auftragen einer Siliciumdioxidschicht zum Erhalt einer planaren Oberfläche auf dem Substrat und

(j) Abtragen des Siliciumdioxids bis zum Siliciumsubstrat.

2. Verfahren zur Herstellung von Isolationsbereichen nach Anspruch 1,
dadurch gekennzeichnet,
daß nach dem Erhitzen des Substrats in Sauerstoffatmosphäre (Schritt h) eine zweite dünne Glasharzschicht aufgetragen und diese in $SiO_2$ umgewandelt wird.

3. Verfahren zur Herstellung von Isolationsbereichen nach den Ansprüchen 1 und 2,
dadurch gekennzeichnet,
daß nach dem Bilden einer dünnen $SiO_2$-Schicht auf der planaren Oberfläche des Siliciumsubstrats und auf den freiliegenden Oberflächen der Gräben (Schritt b) eine $Si_3N_4$-Schicht abgeschieden wird.

4. Verfahren zur Herstellung von Isolationsbereichen nach den Ansprüchen 1 bis 3,
dadurch gekennzeichnet,
daß Gräben mit einer Breite von 2 bis 50 µm und einer Tiefe in der Größenordnung von 4 µm hergestellt werden

5. Verfahren zur Herstellung von Isolationsbereichen nach den Ansprüchen 1 bis 4,
dadurch gekennzeichnet,
daß als Glasharz ein Material aus der Gruppe von Dow-Corning 805, General Electric SR 124 oder SR 125, Owens-Illinois 650 oder Dow-Corning 649 aufgetragen wird.

0025129

1/1

SiO$_2$

Si

FIG. 1

GLASHARZ

MIT ELEKTRONEN-STRAHL BE-LICHTETER BEREICH

Si

FIG. 2

SiO$_2$

GLASHARZ

Si

FIG. 3

PYROLYTISCHES SiO$_2$ (ODER GLASHARZ)

(UMGEWANDELTES GLASHARZ)

Si

FIG. 4

SiO$_2$

SiO$_2$

Si

FIG. 5